Europäisches Patentamt

European Patent Office

Office européen des brevets

(11) Numéro de publication: **0 132 422**
**A1**

# (12) DEMANDE DE BREVET EUROPEEN

(21) Numéro de dépôt: **84401236.9**

(22) Date de dépôt: **15.06.84**

(51) Int. Cl.⁴: **G 01 R 33/04**

(30) Priorité: **24.06.83 FR 8310497**

(43) Date de publication de la demande: **30.01.85**
**Bulletin 85/5**

(84) Etats contractants désignés: **DE GB IT**

(71) Demandeur: **THOMSON-CSF, 173, Boulevard Haussmann, F-75379 Paris Cedex 08 (FR)**

(72) Inventeur: **Desormiere, Bernard, THOMSON-CSF SCPI 173, bld Haussmann, F-75379 Paris Cedex 08 (FR)**

(74) Mandataire: **Desperrier, Jean-Louis et al, THOMSON-CSF SCPI 173, Bld Haussmann, F-75379 Paris Cedex 08 (FR)**

(54) **Sonde à noyau saturable notamment pour magnétomètre.**

(57) L'invention concerne les magnétomètres du type à noyau saturable.

Elle consiste à fabriquer le noyau (20) de la sonde d'un tel magnétomètre avec un alliage métallique amorphe. Pour cela, on enroule un ruban d'un tel matériau sous la forme d'un tube qui est ensuite placé à l'intérieur d'un tube/support (21) isolant et non magnétique. Un recuit se fait à faible température et on garde les propriétés magnétiques et mécaniques du matériau avec une géométrie qui améliore considérablement les caractéristiques magnétiques du noyau.

Elle permet de réaliser des magnétomètres plus sensibles.

## SONDE A NOYAU SATURABLE, NOTAMMENT POUR MAGNETOMETRE

La présente invention se rapporte aux magnétomètres à noyau saturable qui permettent de mesurer le champ magnétique en utilisant un tel noyau comme élément sensible.

On sait réaliser des magnétomètres, connus sous l'appellation anglo-saxonne "fluxgate", dans lesquels on soumet un circuit magnétique, couramment appelé "noyau" magnétique, à un champ magnétique alternatif produit par un courant lui-même alternatif. L'intensité de ce champ alternatif est suffisante pour que le flux qui parcours le circuit magnétique sature celui-ci. Le flux produit dans ce même circuit par le champ à mesurer se superpose au flux du champ de saturation, ce qui produit un déséquilibre dans la courbe d'hystérésis. Un enroulement disposé autour du circuit délivre une tension alternative dont la dissymétrie, due à ce déséquilibre, permet la mesure du champ.

Une revue générale de ce genre de magnétomètre à été faite par Fritz PRIMDAHL dans un article publié dans la revue IEEE TRANSACTION ON MAGNETICS, numéro de Juin 1970 pages 376 à 383. Cet article montre en particulier qu'il existe deux types principaux de magnétomètres à noyau saturable : ceux dont le champ d'excitation est parallèle au champ à mesurer, et ceux dont le champ d'excitation est perpendiculaire au champ à mesurer.

Pour que la mesure du champ magnétique soit la plus ponctuelle possible, il faut que le noyau magnétique soit de petites dimensions.

Par ailleurs les caractéristiques d'un "bon" noyau magnétique sont les suivantes :

- grande perméabilité différentielle $\mu_D = \dfrac{dB}{dH}$ selon les notations habituelles ;

- facilité de mise en oeuvre sous-forme cylindrique ;

- champ coercitif faible ;

- perte par effet Joule faible ;

- magnétostriction quasi nulle ;

- bruit magnétique faible.

On utilise le plus souvent comme matériau sensible pour confectionner le noyau magnétique un matériau ferromagnétique doux du type ferronickel tel que par exemple ceux connus sous les noms de Permalloy ou Mumétal.

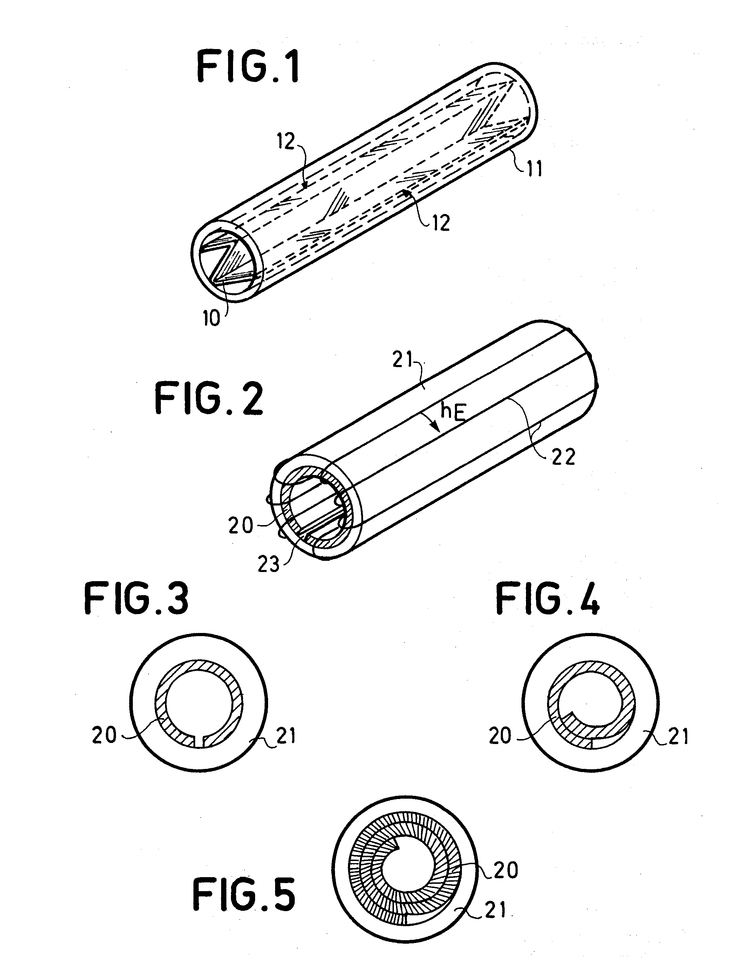

Une technique connue, représentée sur la figure 1, consiste à prendre une feuille de Mumétal 10 pliée en Z selon le sens de la longueur. On introduit cette feuille dans un tube 11 isolant et résistant aux températures élevées, fabriqué par exemple avec du quartz. Les dimensions de la feuille sont telles qu'elle se maintient en place par élasticité dans le tube qui la protège en lui gardant sa forme.

Les caractéristiques du Mumétal, et plus généralement des matériaux de cette nature, sont telles qu'il perd la plus grande partie de sa perméabilité magnétique sous des contraintes mécaniques très faibles, et à fortiori lorsqu'on le plie pour obtenir cette forme en Z.

Pour restaurer ces caractéristiques magnétiques, il faut recuire au-dessus de 1000°C la feuille ainsi contenue dans le tube.

La sensibilité du Mumétal aux déformations est d'ailleurs telle qu'il ne serait pas possible de recuire séparément le noyau, même déjà plié en Z, pour l'introduire ensuite dans le tube.

On bobine ensuite l'enroulement d'excitation sur le tube, puis on remplit celui-ci de magnésie de manière à immobiliser le noyau.

Selon cette technique, on sait réaliser de manière courante des noyaux de 2 mm de diamètre sur 20 mm de long.

Un tel noyau présente un certain nombre d'inconvénients :

- le bobinage n'étant pas fermé, les extrémités 12 de la feuille provoquent l'apparition d'un champ démagnétisant de facteur $\sigma$, ce qui diminue la perméabilité apparente qui devient alors $\mu_a = \dfrac{\mu}{1 + \sigma}$.

- le recuit fait perdre à la feuille son élasticité et la rend fragile. Elle tient alors mal dans le tube, et le bourrage avec de la magnésie ne remédie que partiellement à cet inconvénient car on ne peut pas tasser celle-ci de manière trop forte en raison, d'une part de cette fragilité, et d'autre part de la sensibilité magnétique du matériau aux déformations.

Ces inconvénients sont partiellement évités en enroulant un ruban de Mumétal sur un cylindre semblable à celui de la figure 1. Le bobinage est alors réalisé en faisant passer le fil à l'intérieur du cylindre, ce qui donne un bobinage torique et un champ d'excitation tangentiel au cylindre. D'autres inconvénients apparaissent alors, notamment la difficulté de spiraler le ruban et la nécessité d'avoir un noyau de grande longueur qui ne permet pas une mesure ponctuelle du champ.

Pour pallier ces inconvénients, l'invention propose une sonde à noyau saturable, notamment pour magnétomètre, principalement caractérisée en ce que le noyau est fabriqué avec un matériau magnétique métallique amorphe.

D'autres particularités et avantages de l'invention apparaitront clairement dans la description suivante, faite en regard des figures annexées qui représentent :

- la figure 1, une sonde selon l'art antérieur ;

- la figure 2, une sonde selon l'invention ;

- les figures 3 à 5, des variantes de réalisation de l'enroulement du noyau 20 de la figure 2.

Les métaux obtenus selon les techniques ordinaires présentent une structure polycristalline. On sait maintenant obtenir, par un refroidissement très rapide, de l'ordre du million de degrés par seconde, de certains alliages métalliques en fusion, des métaux présentant une structure amorphe semblable à celle des verres. Pour cette raison ces métaux sont parfois appelés "verres métalliques". Un tel alliage amorphe occupe l'espace d'une façon plus homogène et plus isotrope qu'un métal polycristallin normal, à la manière d'un liquide figé.

Ces métaux amorphes sont remarquables en ce qu'ils sont les seuls matériaux qui possèdent à la fois des qualités mécaniques élevées et une grande perméabilité magnétique, qui est elle-même insensible aux déformations.

De plus l'absence de joints entre grains (inexistants) donne un remplissage spatial continu et supprime les ruptures d'homogénéité des métaux cristallins ordinaires, ce qui réduit l'hystérésis et les pertes ohmiques, et comme il n'y a pas d'anisotropie magnétocristalline et que la magnétostriction est très faible, on obtient une grande perméabilité différentielle $\mu_D = \dfrac{dB}{dH}$.

Leur champ coercitif intrinsèque est du même ordre de grandeur que celui des ferronickels, soit sensiblement 1,5 A/m, et l'induction à saturation peut dépasser, après un traitement thermomagnétique, le Tesla.

Comme ces matériaux ne perdent pratiquement pas leurs propriétés magnétiques lorsqu'ils sont soumis à des contraintes et des déformations, ils sont beaucoup plus facilement manipulables que les ferronickels polycristallins.

Enfin les dissipations d'énergie qui résultent d'une excitation par un champ magnétique variable sont plus faibles, en particulier celles qui sont dues aux courants de Foucault.

On peut citer comme exemple d'un tel matériau, un alliage de formule $(Fe_{0,06} C_{0,94})78 (Si_{0,5} B_{0,5})22$ obtenu sous forme de ruban par hypertrempe. Celui-ci possède un coefficient d'élasticité élevé et sa limite élastique est bien supérieure à celle des aciers.

Pour réaliser une sonde de magnétomètre avec un matériau amorphe, telle que représentée sur la figure 2, on utilise comme support un tube 21, en quartz par exemple, semblable à celui de la figure 1.

On enroule ensuite un morceau de ruban amorphe pour former un tube 20, que l'on pince légèrement pour l'enfiler dans l'intérieur du tube 21. Le matériau amorphe choisi, tel que celui indiqué précédemment, est à magnétostriction minimale.

Le tube 20 a été enroulé avec un diamètre extérieur légèrement inférieur au diamètre intérieur du tube 21 et, lorsqu'on le relâche, sous l'effet de l'élasticité du matériau il vient se plaquer contre la paroi intérieure de ce tube 21, dans lequel il se trouve maintenu sous l'action de cette élasticité.

Les diverses contraintes subies par le matériau amorphe, tant lors de son enroulement que du fait de son maintien par le tube/support, ne font pas perdre à ce matériau amorphe ses propriétés magnétiques, contrairement à ce qui se serait passé si l'on avait utilisé de la même manière par exemple un ruban de Mumétal. De plus si l'on avait utilisé un ruban de Mumétal selon cette structure en tentant de le recuire après montage pour restaurer les propriétés magnétiques du noyau, les contraintes résultant du refroidissement tant du tube/support 20 que du noyau 22 auraient quand même été suffisantes pour réduire les propriétés magnétiques du noyau et pour le fissurer sans toutefois permettre un maintien satisfaisant de celui-ci en place.

Afin de réduire l'anisotropie du matériau, en particulier celle induite par le processus de fabrication, on peut avantageusement effectuer un traitement thermomagnétique, par exemple par un recuit aux alentours de 400°C en présence d'un champ magnétique tournant. Un tel recuit à une température bien inférieure à celle qui est utilisée dans le cas du Mumétal ne nuit en rien aux propriétés magnétiques et mécaniques du matériau amorphe.

Cette disposition de l'élément sensible dans le tube/support permet de réaliser le bobinage d'excitation 22 suivant le sens de la longueur du tube en faisant passer le fil par l'intérieur, ce qui donne une forme torique au bobinage. On obtient ainsi un champ d'excitation $h_e$ tangentiel, et de cette manière le champ démagnétisant est considérablement réduit et donc la perméabilité apparente est plus élevée.

Typiquement, entre une sonde selon l'art antérieur comportant une feuille de Mumétal pliée en Z telle que sur la figure 1 et une sonde selon l'invention telle que sur la figure 2, la perméabilité différentielle, mesurée en traçant les cycles d'hystérésis, est quatre fois supérieure pour la sonde selon l'invention, tandis que le champ coercitif est entre 4 et 5 fois plus faible. Ces différences sont essentiellement dûes dans les deux cas à la forme différente de l'élément sensible.

En conséquence, on obtient l'aimantation à saturation avec un champ d'excitation plus faible, qui peut être obtenu soit par une diminution du nombre de spires de la bobine d'excitation, soit par une diminution du courant dans celle-ci et en conséquence une diminution de la section des fils. Dans les deux cas on peut augmenter le volume du matériau sensible utilisé, et donc la sensibilité de la sonde.

Par ailleurs, l'échauffement par l'hystérésis est moins important, ce qui assure une stabilité plus grande des caractéristiques de la sonde ou éventuellement permet de tolérer un échauffement par effet Joule dans le bobinage plus important et donc de diminuer le volume de ce bobinage.

Les mesures montrent également que l'on constate une diminution du niveau du bruit magnétique, ce qui augmente le rapport signal/bruit du magnétomètre.

Dans l'exemple de réalisation représenté en figure 2, il y a nécessairement un petit entrefer 23 qui se crée entre les deux extrémités du ruban lorsque celui-ci se détend pour venir se plaquer sur la surface intérieure du tube/support. Ceci entraine l'apparition d'un champ démagnétisant qui n'est pas minimal.

Pour minimiser ce champ démagnétisant, on peut faire se recouvrir les deux extrémités du ruban comme représenté en figure 4, ou même utiliser un enroulement multicouches comme représenté en figure 5. En effet, les matériaux amorphes se présentent, en raison des nécessités de leur procédé de fabrication, sous forme de feuilles minces dont l'épaisseur est de l'ordre de 50 µ, ce qui permet de les enrouler facilement sur plusieurs couches. Outre la diminution à une valeur extrêmement faible du champ démagnétisant, ceci permet d'augmenter le volume du matériau utile et d'obtenir une sonde très sensible.

Bien que les résultats les meilleurs soient obtenus avec une bobine torique produisant un champ d'exitation orthogonal au champ à mesurer, on peut également utiliser en variante un enroulement d'excitation coaxial au tube. Dans ce cas le champ d'excitation est parallèle au champ à mesurer et l'on observe l'apparition d'un champ démagnétisant relativement important entre les deux extrémités du tube. Mais on peut alors utiliser un plus grand nombre de couches puisqu'il n'est plus nécessaire de faire passer le fil à l'intérieur du noyau et que l'on peut réduire de beaucoup l'espace vide intérieur à celui-ci. Le choix se fera selon les paramètres que l'on désire optimiser.

REVENDICATIONS

1. Sonde à noyau saturable, notamment pour magnétomètre, caractérisée en ce que le noyau (20) est fabriqué avec un matériau magnétique métallique amorphe.

2. Sonde selon la revendication 1, caractérisée en ce qu'elle comprend un tube/support (21) isolant et non magnétique, et que le noyau (20) est formé d'un ruban enroulé pour former un tube placé de manière coaxiale à l'intérieur du tube/support et qui s'appuie sur la surface intérieure de celui-ci sous l'effet de son élasticité qui tente à le dérouler.

3. Sonde selon la revendication 2, caractérisée en ce que le ruban qui forme le noyau (20) est enroulé sur une seule couche dont les extrémités sont séparées par une fente de largeur juste suffisante pour pouvoir faire pénétrer le noyau à frottement doux dans le tube/support (21) lorsqu'on ferme la fente en pinçant le noyau.

4. Sonde selon la revendication 2, caractérisée en ce que le ruban qui forme le noyau (20) est enroulé sur une seule couche dont les extrémités se recouvrent légèrement pour boucler le circuit magnétique.

5. Sonde selon la revendication 2, caractérisée en ce que le ruban qui forme le noyau (20) est enroulé sur un ensemble de couches superposées.

6. Sonde selon l'une quelconque des revendications 2 à 5, caractérisée en ce qu'elle comprend un enroulement d'excitation (20) bobiné de manière torique avec des spires dont le fil passe à l'extérieur du tube/support (21) et à l'intérieur du noyau (20).

7. Sonde selon l'une quelconque des revendications 2 à 5, caractérisée en ce qu'elle comprend un enroulement d'excitation bobiné sur le tube/support (21) coaxialement à celui-ci.

8. Sonde selon l'une quelconque des revendications 2 à 7, caractérisée en ce que l'ensemble formé du tube/support (21) comprenant le noyau (20) est recuit à une température de l'ordre de 400°C, en présence d'un champ magnétique tournant

9. Sonde selon l'une quelconque des revendications 1 à 8, caractérisée en ce que le matériau amorphe est à magnétostriction minimale.

FIG.1

FIG.2

FIG.3

FIG.4

FIG.5

0132422

Numéro de la demande

**Office européen des brevets**

**RAPPORT DE RECHERCHE EUROPEENNE**

EP 84 40 1236

## DOCUMENTS CONSIDERES COMME PERTINENTS

| Catégorie | Citation du document avec indication, en cas de besoin des parties pertinentes | Revendication concernée | CLASSEMENT DE LA DEMANDE (Int. Cl. ³) |
|---|---|---|---|
| X,P | EP-A-0 098 768 (THOMSOM CSF) <br> * revendications 1,5 * | 1 | G 01 R 33/04 |
| Y | GB-A-2 044 460 (CANADA) <br> * page 1, lignes 98-116 * | 1,2,9 | |
| Y | TECHNISCHE MITTEILUNGEN KRUPP FORSCHUNGSBERICHTE, vol. 40, no. 3, novembre 1982, pages 67-72, Essen, DE; W. JASCHINSKI: "Amorphe Metalle - weichmagnetische Werkstoffe mit Zukunft? " <br> * "introduction"; tableau 1 * | 1,2,9 | |
| A | US-A-3 218 547 (S.C. LING) <br> * colonne 1, lignes 49-66; colonne 2, ligne 50 - colonne 3, ligne 14 * | 2-6 | |
| A | JOURNAL OF APPLIED PHYSICS, vol. 52, no. 3, partie II, mars 1981, American Institute of Physics, New York, US; Y. MAKINO et al.: "Induced magnetic anisotropy of Co-based amorphous alloys" <br> * résumé; "introduction" * | 1,8,9 | |

DOMAINES TECHNIQUES RECHERCHES (Int. Cl. ³)

G 01 R
H 01 F

Le présent rapport de recherche a été établi pour toutes les revendications

| Lieu de la recherche <br> LA HAYE | Date d'achèvement de la recherche <br> 09-10-1984 | Examinateur <br> HAASBROEK J.N. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

OEB Form 1503. 03.82